# EUROPÄISCHE PATENTSCHRIFT

(11) **EP 0 915 343 B1**
(45) Veröffentlichungstag und Bekanntmachung des Hinweises auf die Patenterteilung: **24.03.2004**
(21) Anmeldenummer: 98120165.0
(22) Anmeldetag: 28.10.1998
(51) Int. Cl.: G01R 1/073

(54) **Servicefreundliche Kontaktiervorrichtung**
Service friendly contacting device
Dispositif de contact facile à entretenir

(30) Priorität: 05.11.1997 DE 19748823
(43) Veröffentlichungstag der Anmeldung: 12.05.1999
(73) Patentinhaber: Feinmetall GmbH, 71083 Herrenberg (DE)
(72) Erfinder: Schmid, Rainer, 72124 Pliezhausen (DE); Giringer, Klaus, 71083 Herrenberg (DE); Gauss, Ulrich, 71083 Herrenberg (DE); Deusch, Heinz, 71134 Aidlingen (DE)
(74) Vertreter: Grosse, Rainer, Dipl.-Ing.

(56) Entgegenhaltungen:
- EP-A- 0 406 919
- EP-A- 0 571 879
- WO-A-90/06518
- DE-A- 4 012 839
- DE-A- 4 439 758
- FR-A- 2 535 064
- GB-A- 2 167 610
- US-A- 3 569 789
- US-A- 5 493 230

## Beschreibung

Die Erfindung betrifft eine Kontaktiervorrichtung zum Kontaktieren von nebeneinander angeordneten Prüfpunkten eines elektrischen Prüflings, mit mehreren federnd gelagerten Kontakten.

Vorrichtungen der hier angesprochenen Art sind bekannt (EP 0 068 270 A1 DE 4 012 839, EP 0 406 919 A2 und US 5 493 230). Sie dienen zum gleichzeitigen Kontaktieren von mehreren, eng nebeneinander liegenden Prüfpunkten eines elektrischen Prüflings, beispielsweise eines Halbleiterbauelements. Die bekannten Kontaktiervorrichtungen umfassen eine Anzahl stiftförmiger Kontakte. Zur Überprüfung der Prüfpunkte des elektrischen Prüflings auf Durchgang, Isolation und Funktion, werden die Kontakte und die Prüfpunkte in Anlage miteinander gebracht. Die Kontaktkraft wird durch Ausknicken und/oder Ausfedern der Kontakte senkrecht zu ihrer Längserstreckung beim Aufsetzen der Kontakte auf die Prüfpunkte beziehungsweise der Prüfpunkte auf die Kontakte aufgebracht. Es hat sich gezeigt, daß der Austausch von defekten beziehungsweise nicht mehr in gewünschter Weise funktionierenden Kontaktelementen schwierig und relativ zeitaufwendig ist. Ferner ist nachteilig, daß nur wenig Materialien für die Kontakte verwendet werden können, da nicht jedes Kontaktmaterial ein gutes Federmaterial ist und umgekehrt.

Es ist daher Aufgabe der Erfindung, eine Kontaktiervorrichtung zu schaffen, bei der ein Austausch der Kontakte einfach und relativ schnell möglich ist und bei der eine Vielzahl von Materialien für die Kontakte verwendet werden können.

Zur Lösung der genannten Aufgabe wird eine Kontaktiervorrichtung vorgeschlagen, die die in Anspruch 1 genannten Merkmale aufweist. Diese zeichnet sich dadurch aus, daß die Kontakte als in einem ersten Bauteil axial verschieblich geführte Kontaktelemente ausgebildet sind, die für die federnde Lagerung mit elastischen, in einem zweiten Bauteil angeordnete Gegenkontakte zusammenwirken, wobei das erste Bauteil lösbar an dem zweiten Bauteil befestigt ist. Die Kontaktelemente, die auf den Prüfpunkten des elektrischen Prüflings aufliegen, können aus einem anderen Material als die Gegenkontakte, die die Kontaktelemente gegen die Prüfpunkte mit einer definierten Kraft pressen, bestehen. Hierdurch kann die Kontaktiervorrichtung optimal an die Prüflinge angepaßt werden, beispielsweise kann in einfacher Weise die Kontaktkraft, mit der die Kontaktelemente gegen die Prüfpunkte gepreßt werden, durch einen Austausch des zweiten Bauteils durch ein anderes realisiert werden, dessen Gegenkontakte die gewünschten Materialeigenschaften aufweist. Dadurch, daß das erste Bauteil von dem zweiten Bauteil getrennt werden kann, können auch einzelne, beispielsweise beschädigte Kontaktelemente einfach und schnell ausgetauscht werden.

Dabei sind die Gegenkontakte von auf einer flexiblen Leiterplatte ausgebildeten Kontaktzungen gebildet. Hierdurch kann eine Kontaktiervorrichtung mit einer niedrigen Bauhöhe realisiert werden. Da auf der flexiblen Leiterplatte eine definierte elektrische Impedanz einstellbar ist, wird eine hohe Anpassungsfähigkeit der Kontaktiervorrichtung, beispielsweise an verschiedene Prüflinge und Prüfparameter, erreicht.

Den Gegenkontakten ist ein separates Federelement aus Elastomermaterial zugeordnet, das die Kontaktkraft zwischen den Kontaktelementen und den Prüfpunkten vergrößert. Es ist vorgesehen, daß jedem Gegenkontakt ein Federelement zugeordnet ist, wodurch die Kontaktelemente bei einem Prüfvorgang mit unterschiedlichen Kontaktkräften auf den jeweiligen Prüfpunkt eines elektrischen Prüflings gepreßt werden können.

Weitere vorteilhafte Ausführungsformen ergeben sich aus den übrigen Unteransprüchen.

Die Erfindung wird im folgenden anhand der Zeichnung näher erläutert:

Es zeigen:
- Figur 1: einen schematischen Längsschnitt einer Kontaktiervorrichtung;
- Figuren 2 bis 5: jeweils einen schematischen Längsschnitt eines Ausführungsbeispiels eines ersten Bauteils der Kontaktiervorrichtung;
- Figur 6: einen schematischen Längsschnitts eines Ausführungsbeispiels der Kontaktiervorrichtung;
- Figur 7: eine Draufsicht auf ein Ausführungsbeispiel einer Leiterkarte und
- Figur 8: einen schematischen Längsschnitt durch einen Teil der Kontaktiervorrichtung gemäß Figur 6 im vergrößerten Maßstab.

Die im folgenden beschriebene, auch als Testsondenanordnung bezeichnete Kontaktiervorrichtung dient zur Prüfung elektronischer Bauelemente, deren Prüfpunkte klein sind und eng nebeneinander liegen. Die Kontaktiervorrichtung ist allgemein einsetzbar, insbesondere im Bereich der Halbleitertechnik für den elektrischen Test von Halbleiterbauelementen auf Halbleiterwafern. Die Kontaktiervorrichtung ist grundsätzlich überall dort einsetzbar, wo Prüfpunkte eines elektrischen Prüflings auf Durchgang, Isolation und Funktion überprüft werden sollen.

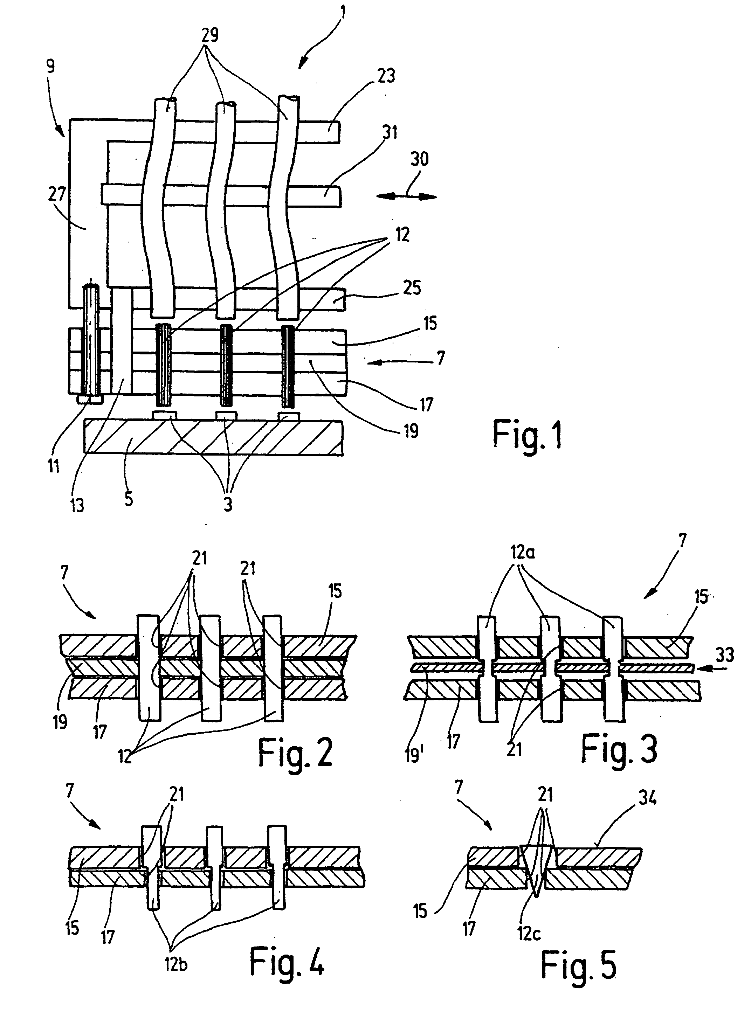

Figur 1 zeigt schematisch einen Ausschnitt Beispiels einer Kontaktiervorrichtung 1 zum Kontaktieren von nebeneinander angeordneten Prüfpunkten 3 eines elektrischen Prüflings 5. Die Kontaktiervorrichtung 1 umfaßt ein erstes Bauteil 7 und ein zweites Bauteil 9, die mittels Befestigungsmittel 11, beispielsweise Schrauben, lösbar miteinander verbunden sind. Zur exakten Positionierung der Bauteile 7, 9 zueinander sind Führungsbolzen vorgesehen, von denen in Figur 1 lediglich der Führungsbolzen 13 erkennbar ist.

In dem ersten Bauteil 7 sind stiftförmige Kontaktelemente 12 axial verschieblich geführt, die jeweils mit einem Prüfpunkt 3 des Prüflings 5 in Anlage gebracht werden können, worauf im folgenden noch näher eingegangen wird. Das erste Bauteil 7 umfaßt eine erste Führungsplatte 15 und eine zweite Führungsplatte 17, zwischen denen eine Halteplatte 19 angeordnet ist. In den Führungsplatten 15, 17 sind für jedes Kontaktelement 12 Durchgangsöffnungen 21 (Figur 2) eingebracht, in denen die Kontaktelemente 12 geführt werden. Die jeweils einem Kontaktelement 12 zugeordneten Durchgangsöffnungen 21 in den Führungsplatten 15, 17 fluchten miteinander. In der aus einem elastischen Material bestehenden Halteplatte 19 ist für jedes Kontaktelement 12 ein Durchbruch eingebracht, dessen lichte Weite kleiner oder gleich ist, wie der Außendurchmesser der Kontaktelemente 12, wodurch diese reibschlüssig in dem jeweiligen Druchbruch in der Halteplatte 19 gehalten werden. Dadurch wird ein Herausfallen der Kontaktelemente 12 aus dem ersten Bauteil 7 verhindert.

Die Führungsplatten 15, 17 bestehen vorzugsweise aus Kunststoff. Bei Verwendung der Kontaktiervorrichtung 1 bei hohen Temperaturen sind Führungsplatten aus Keramik, Glas oder Silizium vorgesehen. Die Halteplatte 19 besteht vorzugsweise aus einem Elastomermaterial, also einem elastischen Kunststoff.

Das zweite Bauteil 9 umfaßt zwei in einem Abstand parallel zueinander angeordnete dritte und vierte Führungsplatten 23 und 25, die über ein Verbindungsteil 27 miteinander verbunden sind. In den Führungsplatten 23, 25 sind in Durchgangslöchern von Drähten gebildete, elastische Gegenkontakte 29 angeordnet, die jeweils mit einem der in dem ersten Bauteil 7 geführten Kontaktelemente 12 zusammenwirken. Die Gegenkontakte 29 bestehen aus einem elektrisch leitenden Material, beispielsweise Federmetall. Das jeweils einem Kontaktelement 12 zugeordnete Durchgangsloch in der dritten und vierten Führungsplatte und die Durchgangsöffnung 21 in der ersten und zweiten Führungsplatte fluchten miteinander. Die Gegenkontakte 29 sind an ihrem aus dem Durchgangsloch in der dritten Führungsplatte 23 herausragenden, den Kontaktelementen 12 abgewandten freien Ende mit einer Prüfeinrichtung, beispielsweise einer Prüfspannungsquelle oder dergleichen verbunden. Das aus dem in der vierten Führungsplatte 25 eingebrachten Durchgangsloch herausragende freie Ende der Gegenkontakte 29 weist in der in Figur 1 dargestellten Bereitschaftsstellung der Kontaktiervorrichtung 1 einen Abstand zu den in dem ersten Bauteil 7 geführten Kontaktelementen 12 auf. Bei einem anderen, nicht dargestellten Ausführungsbeispiel liegt in der Bereitschaftsstellung der Kontaktiereinrichtung das freie Ende der Gegenkontakte an dem zugeordneten Kontaktelement 12 an.

Zwischen den Führungsplatten 23, 25 des zweiten Bauteils 9 ist eine in Richtung eines Doppelpfeils 30 verlagerbare Auslenkplatte 31 vorgesehen, in die Durchgangsbohrungen eingebracht sind, durch die die Gegenkontakte 29 hindurchgeführt werden. Die zu der dritten und vierten Führungsplatte beabstandete Auslenkplatte 31 dient dazu, die Gegenkontakte 29 - in Richtung ihrer Längserstreckung gesehen- definiert auszulenken, so daß bei einer Druckbeaufschlagung der stiftförmigen Gegenkontakte 29 in Längsrichtung deren Knickrichtung festgelegt wird. Ferner wird durch den mittels der Auslenkplatte 31 erzeugten Bogen der Kontaktelemente 29 erreicht, daß diese sich dabei nicht gegenseitig berühren, so daß auf eine elektrische Isolierung der Gegenkontakte 29 gegeneinander gegebenenfalls verzichtet werden kann.

Im folgenden wird die Funktion der Kontaktiervorrichtung 1 anhand eines Prüfvorgangs näher erläutert: In der in Figur 1 dargestellten Bereitschaftsstellung der Kontaktiervorrichtung 1 sind die Gegenkontakte 29 und die Kontaktelemente 12 in einem Abstand zueinander angeordnet. Durch eine Relativbewegung zwischen der Kontaktiervorrichtung 1 und dem Prüfling 5 werden die Kontaktelemente 12 in Anlage mit den Prüfpunkten 3 gebracht. Dabei werden die Kontaktelemente 12 in den Durchgangsöffnungen 21 des ersten Bauteils 7 axial verlagert und gegen die Gegenkontakte 29 gedrückt, die die Kontaktelemente 12 federnd abstützen. Dabei werden die Kontaktelemente 12 mit einer definierten Kraft an die Prüfpunkte 3 gedrückt, wodurch ein geringer elektrischer Kontaktwiderstand erzielt wird. Die Prüfpunkte 3 können nun auf Durchgang und Isolation gegeneinander hin beziehungsweise der Prüfling 5 auf Funktion überprüft werden. Nachdem der Prüfvorgang abgeschlossen ist, werden die Kontaktiervorrichtung 1 und der Prüfling 5 durch eine Relativbewegung voneinander getrennt. Die durch das Andrücken der Kontaktelemente 12 ausgelenkten Gegenkontakte verlagern sich aufgrund ihrer elastischen Eigenschaften selbsttätig in ihre in Figur 1 dargestellte Ausgangsstellung zurück, ebenso wie die von der elastischen Halteplatte 19 gehaltenen Kontaktelemente 12.

Figur 2 zeigt eine Detailansicht des in Figur 1 dargestellten ersten Bauteils 7. Es wird deutlich, daß die Kontaktelemente 12 in den in den Führungsplatten 15, 17 eingebrachten Durchgangsöffnungen 21 mit einem Spiel geführt und in dem zugeordneten Durchbruch in der Halteplatte 19, dessen Durchmesser kleiner oder gleich ist wie der Außendurchmesser des darin angeordneten Kontaktelements 12, reibschlüssig gehalten werden. Die Führungsplatten 15, 17 und die Halteplatte 19 können -wie in Figur 2 dargestellt- zueinander beabstandet sein oder -nach einem weiteren, nicht dargestellten Ausführungsbeispiel- aufeinander liegen.

Figur 3 zeigt ein weiteres Ausführungsbeispiel des ersten Bauteils 7. Die Führungsplatten 15, 17 sind hier in einem Abstand zueinander angeordnet, wodurch ein Zwischenraum 33 gebildet ist, in den eine Ausführungsform der Halteplatte 19' eingebracht ist. Die Halteplatte 19', deren Höhe geringer ist als die des Zwischenraums 33, wird zu den Führungsplatten 15, 17 beabstandet gehalten. Die in jeweils einen Durchbruch der Halteplatte 19' eingebrachten Kontaktelemente 12a weisen eine umlaufende Ringnut auf, in die die Halteplatte 19' eingreift, wodurch ein mechanischer Formschluß gebildet ist. Durch den Spalt zwischen der Halteplatte 19' und den Führungsplatten 15, 17 wird die Halteplatte 19' beim Kontaktieren der Kontaktelemente 12a mit den Prüfpunkten im Bereich ihrer Durchbrüche ausgelenkt, das heißt, die Kontaktelemente 12a werden in axialer Richtung verlagert und federn nach Entlastung in ihre Ausgangsstellung zurück.

Das in Figur 4 dargestellte dritte Ausführungsbeispiel des ersten Bauteils 7 unterscheidet sich von den vorangegangenen insbesondere dadurch, daß keine Halteplatte vorgesehen ist, die die Kontaktelemente 12b gegen ein Verlieren sichert. Die in die erste Führungsplatte 15 eingebrachten Durchgangsöffnungen 21 weisen einen größeren Durchmesser auf, als die Durchgangsöffnungen 21 in der zweiten Führungsplatte 17, so daß im zusammengebauten Zustand des ersten Bauteils 7, in dem die Führungsplatten 15, 17 flächig aufeinander liegen, Stufenbohrungen gebildet werden. Die Außenkontur der in den Durchgangsöffnungen 21 axial verschieblich geführten Kontaktelemente 12b ist an die Form der Durchgangsöffnungen angepaßt und weist daher zwei Bereiche mit unterschiedlichen Durchmessern auf. Dadurch wird eine Ringstufe gebildet, mit der die Kontaktelemente 12b auf der Seitenfläche der zweiten Führungsplatte 17 aufliegen und somit gegen Herausfallen der Kontaktelemente 12b aus dem ersten Bauteil 7 gesichert sind.

Figur 5 zeigt ein viertes Ausführungsbeispiel des ersten Bauteils 7 mit einer vierten Ausführungsform des Kontaktelements 12c, das hier eine konische Form aufweist. Der größte Durchmesser des Konus ist größer als der Durchmesser der in die zweite Führungsplatte 17 eingebrachten Durchgangsöffnung 21, so daß auch bei diesem Ausführungsbeispiel -wie bei dem in Figur 4 dargestellten Ausführungsbeispielein Herausfallen des Kontaktelements 12c aus dem ersten Bauteil 7 durch einen mechanischen Formschluß verhindert wird. Der Durchmesser der Durchgangsöffnung 21 in der ersten Führungsplatte ist größer als der große Durchmesser des Kontaktelements 12c. Dessen Höhe ist in Figur 5 rein beispielhaft so gewählt, daß die Grundfläche des Kontaktelements 12c, an der sich beim Kontaktieren ein Gegenkontakt 29 abstützt, in der Bereitschaftsstellung der Kontaktiervorrichtung 1 bündig mit der Seitenfläche 34 der ersten Führungsplatte 15 abschließt. Alternativ zu der in Figur 5 dargestellten Stufenbohrung in den Führungsplatten 15, 17 können die Durchgangsöffnungen 21 eine konische Form aufweisen, so daß das Kontaktelement 12c reibschlüssig im ersten Bauteil 7 gehalten wird.

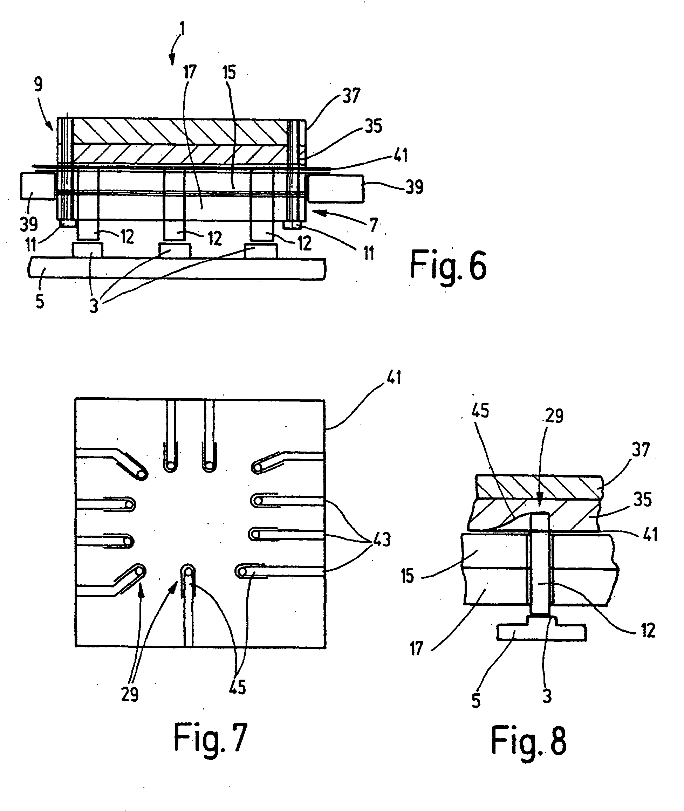

Figur 6 zeigt einen Ausschnitt eines Ausführungsbeispiels der Kontaktiervorrichtung 1. Gleiche Teile sind mit gleichen Bezugszeichen versehen, so daß insofern auf die Beschreibung zu den vorangegangenen Figuren verwiesen wird. Im folgenden soll lediglich auf die Unterschiede näher eingegangen werden. Das zweite Bauteil 9 umfaßt ein aus einem Elastomermaterial bestehendes Federelement 35, das auf einer Abstützplatte 37 befestigt ist. Das Federelement 35 dient der federnden Lagerung der Kontaktelemente 12. Die elektrische Verbindung der in dem ersten Bauteil 7 axial verschieblich geführten Kontaktelemente 12 mit einer Prüfeinheit 39, beispielsweise einer auch als "Probe Card Board" bezeichneten Prüfkarte, wird über eine flexible Leiterkarte 41 hergestellt, auf der sich die Gegenkontakte für die Kontaktelemente 12 befinden. Die Höhe der Leiterkarte 41 ist gegenüber der des ersten und zweiten Bauteils 7 beziehungsweise 9 sehr gering. Dadurch ist eine kompakte Kontaktiervorrichtung 1 mit einer niedrigen Bauhöhe realisierbar.

Wie aus Figur 7 ersichtlich, die eine Draufsicht auf die in Figur 6 dargestellte Leiterkarte 41 zeigt, sind bei dem Ausführungsbeispiel die Gegenkontakte 29 als in die flexible Leiterkarte 41 eingebrachte Kontaktzungen 45 ausgebildet, deren Funktion anhand von Figur 8 näher erläutert wird. Die Kontaktzungen 45 sind über auf der Leiterkarte 41 vorgesehene Leiterbahnen 43 mit der Prüfeinheit 39 verbunden. Dadurch, daß auf der Leiterkarte 41 sowohl die Gegenkontakte 29 angeordnet sind, als auch die elektrischen Verbindungen, also die Leiterbahnen 43, sind die elektrischen Wege sehr kurz. Ferner kann auf der flexiblen Leiterplatte 41 eine definierte Impedanz eingestellt werden, wodurch die Anpassungsfähigkeit der Kontaktiervorrichtung 1 an unterschiedliche Prüflinge und/oder Prüfparameter, zum Beispiel die Größe der Kontaktkraft, verbessert wird. Die Anzahl und Anordnung der auf der Leiterkarte 41 angeordneten Gegenkontakte entspricht der der Prüfpunkte 3 des Prüflings 5. Das heißt, für jede Ausführungsform des Prüflings 5 ist eine speziell an diesen angepaßte Leiterkarte 41 vorgesehen. Da das erste und zweite Bauteil lösbar miteinander verbunden sind und die Leiterkarte 41 dazwischen liegend angeordnet ist, kann diese in kurzer Zeit ausgewechselt und somit die Kontaktiervorrichtung 1 an einen anderen Prüfling angepaßt werden.

Figur 8 zeigt im vergrößerten Maßstab ein als Federzunge 45 ausgebildeter Gegenkontakt 29, der in die Leiterkarte 41 eingebracht ist. Bei einer Relativbewegung zwischen dem Prüfling 5 und der Kontaktiervorrichtung 1 wird das Kontaktelement 12 in Anlage mit dem Prüfpunkt 3 gebracht und axial in Richtung des zweiten Bauteils 9 verlagert. Dabei wird das Kontaktelement 12 gegen die Kontaktzunge 45 in der Leiterkarte 41 gedrückt, wodurch diese ausgelenkt wird. Die Kontaktzunge 45 stützt sich wiederum an dem Federelement 35 ab, das die Kontaktkraft zwischen Kontaktelement 12 und Prüfpunkt 3 aufbringt.

Zusammenfassend ist festzuhalten, daß durch den erfindungsgemäßen Aufbau der Kontaktiervorrichtung 1 unterschiedliche Materialien für das Kontaktelement und den Gegenkontakt verwendet werden können. Dadurch wird die Funktion der Kontaktiervorrichtung 1 verbessert. Ferner ermöglicht das Ausführungsbeispiel, bei dem die Gegenkontakte auf einer dünnen, elastischen Leiterkarte 41 eingebracht sind, eine Miniaturisierung der Kontaktvorrichtung.

## Patentansprüche

1. Zum Kontaktieren von nebeneinander angeordneten Prüfpunkten eines elektrischen Prüflings vorgesehene Kontaktiervorrichtung (1) mit mehreren federnd gelagerten Kontakten, die als in einem ersten Bauteil (7) axial verschieblich geführte Kontaktelemente (12,12A,12B,12C) ausgebildet sind, die für ihre federnde Lagerung mit elastischen, in einem zweiten Bauteil (9) angeordneten Gegenkontakten (29) zusammenwirken, wobei die Gegenkontakte (29) von auf einer flexiblen Leiterkarte (41) ausgebildeten Kontaktzungen (45) gebildet sind, **gekennzeichnet dadurch, daß** den Kontaktzungen ein Federelement (35) aus einem Elastomermaterial zugeordnet ist.

2. Kontaktiervorrichtung nach Anspruch 1 , **dadurch gekennzeichnet, daß** das erste Bauteil (7) eine Führung aus mindestens zwei flächig aufeinander liegenden oder zueinander beabstandeten, insbesondere parallel beabstandeten Führungsplatten (15,17) umfaßt, in denen für jedes Kontaktelement (12;12a;12b;12c) fluchtende Durchgangsöffnungen (21) eingebracht sind.

3. Kontaktiervorrichtung nach Anspruch 2, **dadurch gekennzeichnet, daß** den Führungsplatten (15,17) eine die Kontaktelemente (12;12a) gegen Herausfallen aus dem ersten Bauteil (7) sichernde Halteplatte (19) zugeordnet ist.

4. Kontaktiervorrichtung nach Anspruch 3, **dadurch gekennzeichnet, daß** die Halteplatte (19;19') zwischen den Führungsplatten (15,17) angeordnet ist.

5. Kontaktiervorrichtung nach Anspruch 3 oder 4, **dadurch gekennzeichnet, daß** die aus einem elastischen Material bestehende Halteplatte (19) für jedes Kontaktelement (12) einen Durchbruch aufweist, in dem das Kontaktelement (12) reibschlüssig gehalten ist.

6. Kontaktiervorrichtung nach einem der henden Ansprüche 3-5, **dadurch gekennzeichnet, daß** die Halteplatte (19') für jedes Kontaktelement (12a) einen Durchbruch aufweist, in dem das Kontaktelement (12a) formschlüssig gehalten ist.

7. Kontaktiervorrichtung nach einem der Ansprüche 2-5, **dadurch gekennzeichnet, daß** die Durchgangsöffnungen als Stufenbohrungen ausgebildet sind, wobei der den kleineren Durchmesser aufweisende Teil der Stufenbohrung in einer ersten Führungsplatte (17) der Fürung und der den großen Durchmesser aufweisende Teil der Stufenbohrung in einer zweiten Führungsplatte (15) der Führung eingebracht sind.

8. Kontaktiervorrichtung nach einem der Ansprüche 2-7, **dadurch gekennzeichnet, daß** die Außenkontur der Kontaktelemente (12;12b;12c) an die Form der Durchgangsöffnungen angepaßt ist.

## Claims

1. A contacting device (1) provided for contacting juxtaposed test points of an electric test piece, having a plurality of resiliently mounted contacts which are in the form of contact elements (12,12a,12b,12c) which are guided axially displaceably in a first component (7) and which for their resilient mounting cooperate with their elastic opposing contacts (29) disposed in a second component (9), wherein the opposing contacts (29) are formed by contact tongues (45) formed on a flexible printed circuit card (41), **characterised in that** a spring element (35) consisting of an elastomeric material is associated with the contact tongues.

2. A contacting device according to claim 1, **characterised in that** the first component (7) comprises a guide consisting of at least two guide panels (15,17) which are disposed on one another in a laminar manner or which are spaced apart, in particular spaced apart parallel, and in which aligned through-openings (21) are incorporated for each contact element (12;12a;12b;12c).

3. A contacting device according to claim 2, **characterised in that** the guide panels (15,17) are associated with a retaining panel (19) preventing the contact elements (12;12a) from dropping out of the first component (7).

4. A contacting device according to claim 3, **characterised in that** the retaining panel (19;19') is disposed between the guide panels (15,17).

5. A contacting device according to claim 3 or 4, **characterised in that** the retaining panel (19) consisting of an elastic material has for each contact element (12) an opening in which the contact element (12) is retained in a frictionally engaged manner.

6. A contacting device according to any one of claims 3 to 5, **characterised in that** the retaining panel (19') has for each contact element (12a) an opening in which the contact element (12a) is retained in a form-locking manner.

7. A contacting device according to any one of claims 2 to 5, **characterised in that** the through-openings are in the form of stepped bores, wherein the part of the stepped bore having the smaller diameter is incorporated in a first guide panel (17) of the guide and the part of the stepped bore having the large diameter is incorporated in a second guide panel (15) of the guide.

8. A contacting device according to any one of claims 2 to 7, **characterised in that** the outer contour of the contact elements (12;12b;12c) is adapted to the shape of the through-openings.

## Revendications

1. Dispositif de contact pour le contact de points tests disposés les uns à côté des autres d'un échantillon électrique, dispositif de contact (1) prévu avec plusieurs contacts montés sur ressorts qui sont configurés comme des éléments de contact (12,12a,12b,12c) guidés par glissement axial dans un premier composant (7), qui coopèrent pour leur logement à ressorts avec des contre-contacts (29) élastiques disposés dans un second composant (9), les contre-contacts (29) étant formés par des lames de contact (45) configurées sur une carte à circuits imprimés (41) flexible, **caractérisé en ce qu'**un élément à ressort (35) en matériau élastomère est attribué aux lames de contact.

2. Dispositif de contact selon la revendication 1, **caractérisé en ce que** le premier composant (7) comprend un guidage composé d'au moins deux plaques de guidage (15,17) planes situées l'une sur l'autre ou séparées l'une de l'autre, en particulier séparées parallèlement l'une de l'autre, dans lesquelles sont réalisés des orifices de passage alignés (21) pour chaque élément de contact (12,12a,12b,12c).

3. Dispositif de contact selon la revendication 2, **caractérisé en ce qu'**une plaque de retenue (19) évitant la chute des éléments de contact (12,12a) hors du premier composant (7) est attribuée aux plaques de guidage (15,17).

4. Dispositif de contact selon la revendication 3, **caractérisé en ce que** la plaque de retenue (19,19') est disposée entre les plaques de guidage (15,17).

5. Dispositif de contact selon la revendication 3 ou 4, **caractérisé en ce que** la plaque de retenue (19) composée d'un matériau élastique comprend pour chaque élément de contact (12) une ouverture dans laquelle est retenu par friction l'élément de contact (12).

6. Dispositif de contact selon l'une des revendications 3-5, **caractérisé en ce que** la plaque de retenue (19') comprend pour chaque élément de contact (12a) une ouverture dans laquelle est retenu par complémentarité de forme l'élément de contact (12a).

7. Dispositif de contact selon l'une des revendications 2-5, **caractérisé en ce que** les orifices de passage sont configurés comme des alésages étagés, la partie comprenant le diamètre le plus petit de l'alésage étagé étant placée dans une première plaque de guidage (17) du guidage, et la partie comprenant le diamètre supérieur de l'alésage étagé étant placée dans une seconde plaque de guidage (15) du guidage.

8. Dispositif de contact selon l'une des revendications 2-7, **caractérisé en ce que** le contour externe des éléments de contact (12,12b,12c) est adapté à la forme des orifices de passage.
